# EUROPÄISCHE PATENTSCHRIFT

(11) **EP 2 478 753 B1**
(45) Veröffentlichungstag und Bekanntmachung des Hinweises auf die Patenterteilung: **26.03.2014**
(21) Anmeldenummer: 10750109.0
(22) Anmeldetag: 01.09.2010
(51) Int. Cl.: H05K 3/40, C04B 41/52, H05K 1/03

(54) **VERFAHREN ZUR HERSTELLUNG EINES KERAMIKBAUTEILS, KERAMIKBAUTEIL**
METHOD FOR PRODUCING A CERAMIC COMPONENT, CERAMIC COMPONENT
PROCÉDÉ DE FABRICATION D'UN COMPOSANT EN CÉRAMIQUE, COMPOSANT EN CÉRAMIQUE

(30) Priorität: 15.09.2009 DE 102009029485
(43) Veröffentlichungstag der Anmeldung: 25.07.2012
(73) Patentinhaber: Robert Bosch GmbH, 70442 Stuttgart (DE)
(72) Erfinder: GRADTKE, Oliver, 72766 Reutlingen (DE); WICKETT, Paul, Northville MI 48167 (US); ROETHLINGSHOEFER, Walter, 72766 Reutlingen (DE)
(86) Internationale Anmeldenummer: PCT/EP2010/062780
(87) Internationale Veröffentlichungsnummer: WO 2011/032838

(56) Entgegenhaltungen:
- EP-A2- 0 165 575
- GB-A- 2 277 202
- US-A- 4 237 606
- US-A- 4 767 672
- US-A- 5 035 939
- US-A1- 2005 078 433

## Beschreibung

Die Erfindung betrifft ein Verfahren zur Herstellung eines Keramikbauteils. Des Weiteren betrifft die Erfindung ein Keramikbauteil und eine Bauteitanordnung, die ein Keramikbauteil und ein Anschlussbauteil umfasst.

### Stand der Technik

Es ist bekannt, keramische Materialien als Substrate für elektronische Bauteile einzusetzen. Beispielsweise offenbart die US 6,800,815 B1 ein elektronisches Bauteil, welches ein mehrlagiges Keramiksubstrat sowie eine Vielzahl, von Leiterbahnen, die im Innern und/oder an der Oberfläche des Keramiksubstrats verlaufen, umfasst. An der Unterseite des Bauteils befinden sich mehrere Anschlusskontakte, über die die Leiterbahnen von außen elektrisch kontaktiert werden können. Das elektronische Bauteil ist mittels eines BGA (Ball Grid Array) auf eine Platine aufgelötet. Das BGA verbindet die Anschlusskontakte des elektronischen Bauteils elektrisch mit der Platine.

Desweiteren beschreibt die US 4,237,606 A ein Verfahren zu Herstellung einer mehrlagigen keramischen Platte, gekennzeichnet durch eine gebrannte keramische Platte mit mehreren leitfähigen Rücken auf der gebrannten keramischen Platte und durch eine Platte für eine Verdrahtung auf der Oberfläche mit Durchgangslöchern in Kontakt mit dem leitfähigen Rücken, wobei ein Verdrahtungsmuster mit den auf der Oberfläche der Verdrahtungsplatte gebildeten Durchgangslöchern verbunden ist.

Die US 2005/078433 A1 hingegen berichtet über ein keramisches Substrat zur Verwendung als elektronische Dünnschichtkomponente, ein Verfahren zur dessen Herstellung und Bauteile enthaltend dieses Substrat. Die Komponenten enthalten ein erstes keramisches Substrat mit definierter Oberflächenrauigkeit; ein zweites keramisches Substrat, wobei das zweite keramische Substrat dadurch gebildet wird, dass durch eine Hitze- und Druckbehandlung eine Glas- oder Glasurschicht auf der Oberfläche eines Substrates gebildet und die Oberfläche der Glasur anschließend poliert wird; und ein drittes keramisches Substrat enthaltend ein Substrat, eine porenlose, polierte Glasur auf dem Substrat und eine Verdrahtung, wobei wenigstens ein erstes Verdrahtungsende in Richtung der glasierten Oberfläche des Substrates und das zweite Verdrahtungsende an der gegenüberliegende Seite des Substrates liegt.

Zudem offenbart die EP 0 165 575 A2 ein Verfahren zur Herstellung eines durchgehenden Verbundes mehrerer Halbleiter oder mehrlagige, integrierte Schaltungen. Mittels eines Prozesses, welcher vertikale, leitende Verbindungen oder Bolzen zwischen planaren, leitfähigen Lagen einführt wird eine mehrlagige Glas-Überstruktur mit einer mehrschichteigen Verteilung planarer Leiter erhalten.

Weitere Verfahren zur Herstellung keramischer Substrate oder Schaltplatinen lassen sich zum Beispiel der US 4,767,672 A und der US 5,035,939 A entnehmen.

### Offenbarung der Erfindung

Gegenstand der Erfindung ist ein Verfahren zur Herstellung eines Keramikbauteils, umfassend die Schritte: a) Bereitstellen eines Keramiksubstrates, wobei sich im Innern und/oder an der Oberfläche des Keramiksubstrates eine Leiterbahn befindet und das Keramiksubstrat zumindest bereichsweise mit einer Glasur bedeckt ist; und vor dem Aufbringen der Glasur (5) auf das Keramiksubstrat (2) ein Antihaftmittel (8) auf den Kontaktbereich (15) der Leiterbahn (3) aufgebracht wird; b) Erzeugen einer Kontaktierungsöffnung in der Glasur in einem zu kontaktierenden Bereich der Leiterbahn; c) Aufbringen einer metallischen Schicht im Bereich der Kontaktierungsöffnung zum Kontaktieren der Leiterbahn.

Ein weiterer Gegenstand der Erfindung ist ein Keramikbauteil,umfassend ein Keramiksubstrat (2), eine das Keramiksubstrat (2) zumindest bereichsweise bedeckende Glasur (5), und eine sich im Inneren und/oder an der Oberfläche des Keramiksubstrates (2) befindende Leiterbahn (3), wobei sich zwischen dem jeweiligen Kontaktbereich (15) der Leiterbahn (3) und der Glasur (5) eine Schicht aus einem Antihaftmittel (8) befindet. Durch die Glasur kann eine Schutzschicht und/oder Isolationsschicht bereitgestellt werden, mittels der insbesondere elektrische Komponenten des Keramikbauteils, beispielsweise Widerstände oder Leiterbahnen, mechanisch und/oder elektrisch geschützt werden können. Auch das Keramiksubstrat an sich kann durch eine derartige Glasur geschützt werden. Die Glasur kann vorteilhaft im Rahmen des Herstellungsprozesses des Keramiksubstrates auf dieses und mit dem Keramiksubstrat verbundene Komponenten aufgebracht werden.

Das erfindungsgemäße Verfahren ermöglicht es, von der Glasur bedeckte Leiterbahnen einer äußeren Kontaktierung zugänglich zu machen. Derartige Leiterbahnen können sowohl elektrische als auch thermische Leiterbahnen für das Leiten eines Stromes oder der Übertragung von Wärme sein. Durch Öffnen der Glasur in dem zu kontaktierenden Bereich der Leiterbahn und durch Aufbringen einer metallischen Schicht kann ein metallischer Anschlusskontakt ausgebildet werden. Insbesondere können auf diese Weise eine Vielzahl von Anschlusskontakten erzeugt werden, die, an einer gemeinsamen Rückseite des Keramikbauteils angeordnet, beispielsweise mittels eines BGA für den elektrischen Anschlusses des Keramikbauteils an ein weiteres Bauteil versehen werden können.

Weitere vorteilhafte Ausführungsformen der Erfindung sind Gegenstände der abhängigen Ansprüche.

Die Erfindung wird im Folgenden anhand von Ausführungsformen, die durch Zeichnungen dargestellt sind, näher erläutert.

### Kurze Beschreibung der Zeichnungen

Es zeigen:
- Fig. 1: einen Querschnitt durch eine sich in der Herstellung befindende Ausführungsform eines erfindungsgemäßen Keramikbauteils, wobei, das Keramikbauteil ein Keramiksubstrat umfasst, das bereichsweise mit einer Glasur bedeckt ist,
- Fig. 2: das in Fig. 1 gezeigte sich in der Herstellung befindende Keramikbauteil nach dem Erzeugen von Kontaktierungsöffnungen in der Glasur,
- Fig. 3: das in Fig. 2 gezeigte, sich in der Herstellung befindende Keramikbauteil nach dem Aufbringen einer metallischen Schicht jeweils im Bereich der Kontaktierungsöffnungen, und
- Fig. 4: eine Unteransicht des fertigen Keramikbauteils, das mit einem BGA versehen ist, vor dem Verbinden mit einem Anschlussbauteil.

### Ausführungsform(en) der Erfindung

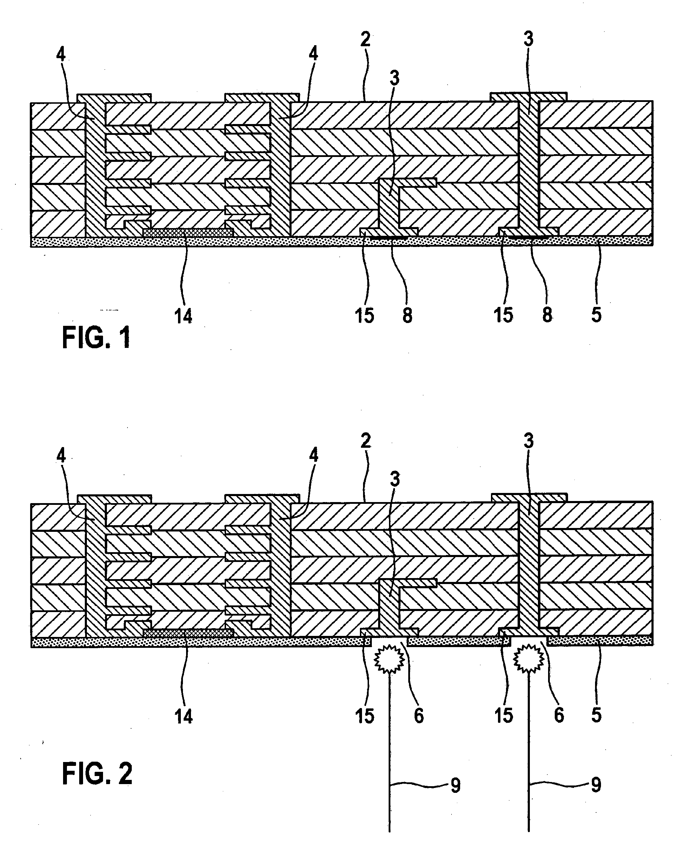

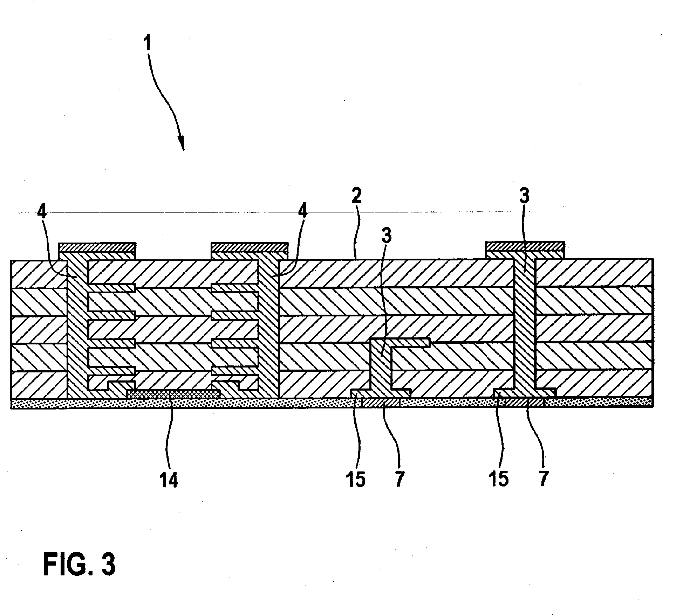

Die Fig. 1 bis 3 zeigen verschiedene Zustände einer Ausführungsform eines erfindungsgemäßen Keramikbauteils 1 bei seiner Herstellung gemäß einer Ausführungsform eines erfindungsgemäßen Verfahrens. Fig. 3 zeigt das fertige Keramikbauteil 1.

Für die Herstellung des Keramikbauteifs 1 wird zunächst ein Keramiksubstrat 2 bereitgestellt, dessen Oberfläche zumindest bereichsweise mit einer Glasur 5 bedeckt ist. In diesem Ausführungsbeispiel ist das Keramiksubstrat 2 ein Keramiksubstrat mit mehreren Substratlagen. Die Glasur 5 bedeckt die Unterseite des Keramiksubstrats 2. Des Weiteren befinden sich im Innern und an der Oberfläche des Keramiksubstrates 2 mehrere Leiterbahnen 3, 4, die beispielsweise auf der Basis von Silber hergesteflt sind. Die Leiterbahnen sind abschnittsweise als Durchkontaktierungen ausgebildet und kontaktieren insbesondere einen oder mehrere Widerstände 14, die auf der Rückseite des Keramiksubstrates 2 angeordnet sind und von der Glasur 5 bedeckt werden. Die weiteren, in der Fig. 1 dargestellten Leiterbahnen 3 umfassen ebenfalls Durchkontaktierungen. Insbesondere weisen die Leiterbahnen 3 einen Kontaktierungsbereich 15 auf, der sich auf der Rückseite des Keramiksubstrats 2 befindet, und der ebenfalls von der Glasur 5 bedeckt ist. Die Leiterbahnen 4 sind für die Leitung von elektrischem Strom ausgebildet. Die Leiterbahnen 3 können thermische und/oder elektrische Leiterbahnen sein.

Des Weiteren befindet sich zwischen dem jeweiligen Kontaktbereich 15 der Leiterbahnen 3 und der Glasur 5 eine Schicht aus einem Antihaftmittel 8. Das Antihaftmittel 8 hat den Zweck, das Öffnen der Glasur im Bereich der Kontaktbereiche 15 der Leiterbahnen 3 zu vereinfachen.

Die Prozesse zur Herstellung des in Fig. 1 gezeigten Zwischenzustandes des Keramikbauteiles 1 sind dem Fachmann hinlänglich bekannt. Die einzelnen Lagen des Keramiksubstrates 2, mit Leiterbahnen versehen und ggf. mit elektrischen Komponenten bestückt, können mittels eines Sinterprozesses zusammengefügt werden. Im Rahmen dieses Prozesses erfolgt vorteilhafter Weise die Auftragung der Glasur 5. Vor dem Aufbringen der Glasur 5 wird auf den Kontaktbereich 15 der jeweiligen Leiterbahnen 3 das Antihaftmittel 8 aufgebracht. Das Antihaftmittel 8 ist bevorzugt ein Keramikpulver, dessen Sintertemperatur größer ist als die Erweichungstemperatur der Glasur 5. Als derartiges Antihaftmittel 8 eignet sich beispielsweise ein Aluminiumoxid-Keramikpulver.

Um die Kontaktbereiche 15 der Leiterbahnen 3 freizulegen, wird in einem nachfolgenden Schritt im Bereich des jeweiligen Kontaktbereiches 15 eine Kontaktierungsöffnung 6 in der Glasur 5 erzeugt. Die Kontaktierungsöffnung 6 wird in diesem Ausführungsbeispiel durch Bestrahlen der Glasur 5 mittels eines Material abtragenden Strahls 9 erzielt. Ein derartiger Strahl 9 kann insbesondere ein Laserstrahl oder ein Wasserstrahl sein. Bei der Verwendung eines Wasserstrahls ist es vorteilhaft, diesem ein Abrasivmittel zuzusetzen, um dessen Material abtragende Wirkung zu erhöhen. Im Falle der Verwendung eines Lasers 9 ist es möglich, eine Glasur 5 mit einem Zusatz zu verwenden, der die Absorption der Laserstrahlung innerhalb der Glasur 5 fördert.

Die Bestrahlung der Glasur 5 im Bereich der Kontaktbereiche 15 erfolgt solange, bis die Glasur 5 in diesem Bereich abgetragen ist. Das Antihaftmittel 8 fördert die Erzeugung der Kontaktierungsöffnungen 6, da es in dem Bereich, indem es aufgetragen ist, eine feste Verbindung der Glasur 5 mit dem Kontaktbereich 15 unterbindet.

Die Bestrahlung wird fortgesetzt, bis auch das Antihaftmittel 8 entfernt ist und der Kontaktbereich 15 der jeweiligen Leiterbahn 3 freiliegt. Das Entfernen der Glasur 5 zum Erzeugen der Kontaktierungsöffnung 6 und das Entfernen des Antihaftmittels 8 können sich insbesondere überschneiden. Den Verfahrenzustand nach Beendigung dieses Schrittes zeigt die Fig. 2.

Grundsätzlich ist es ebenfalls möglich, auf ein Antihaftmittel 8, das zwischen Kontaktbereichen 15 und Glasur 5 angeordnet ist, zu verzichten. Das Erzeugen der Kontaktierungsöffnungen 6 in der Glasur kann in diesem Falle ebenfalls durch Bestrahlen mit einem Material abtragenden Strahl 9, insbesondere wie oben beschrieben, erfolgen.

In einem nachfolgenden Schritt wird eine metallische Schicht 7 im Bereich der Kontaktierungsöffnung 6 zum Kontaktieren der Kontaktbereiche 15 der Leiterbahn 3 aufgebracht.

Zum Aufbringen der metallischen Schicht 7 kann beispielsweise ein chemisch-stromloses Beschichtungsverfahren verwendet werden, was erfindungsgemäß bevorzugt ist. Die Beschichtung kann mit einer Plating-Anlage erfolgen. Auf diese Weise kann gezielt auf die offenliegenden Bereiche der Leiterbahnen 3, 4, insbesondere auf die Kontaktbereiche 15, abgeschieden werden. Eine Abscheidung direkt auf die Oberfläche des Keramiksubstrates 2 oder auf die Oberfläche der Glasur 5 kann vermieden werden. Die metallische Schicht 7 kann beispielsweise durch eine Nickel-Palladium-Gold-Metallisierung hergestellt werden.

Die Fig. 3 zeigt das Keramikbauteil 1 nach dem Aufbringen der metallischen Schicht 7.

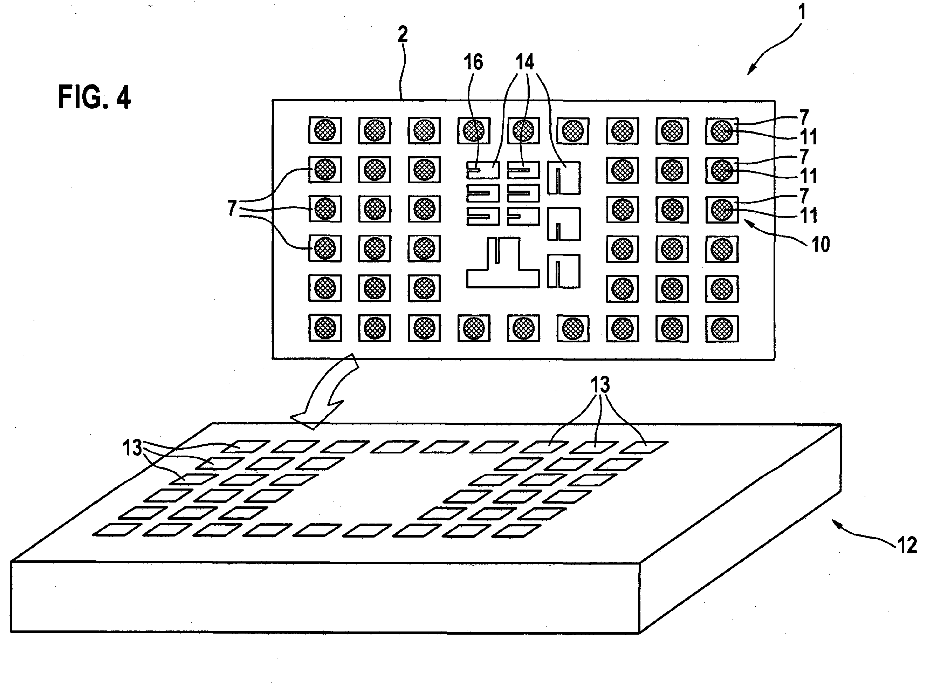

Grundsätzlich können sich nach diesem Schritt weitere Verfahrensschritte anschließen. Beispielsweise kann das Keramikbauteil 1 mit weiteren elektrischen Komponenten bestückt werden. Des Weiteren kann ein Trimmen der Widerstände 14, falls nicht im Rahmen der Erzeugung der Kontaktierungsöffnungen 6 durchgeführt, erfolgen. Zum Trimmen der Widerstände 14 wird in einem Widerstand 14 vorzugsweise mittels eines Lasers ein Schnitt 16, siehe hierzu Fig. 4, gesetzt. Auf diese Weise lässt sich der Widerstand eines Widerstandes 14 erhöhen.

Die metallische Schicht 7, die auf den Kontaktbereichen 15 der Leiterbahnen 3 aufgebracht ist, bildet einen Anschlusskontakt ("Pad") für die externe Kontaktierung der Leiterbahnen 3 aus. Je nach Bedarf kann eine Vielzahl derartiger Anschlusskontakte vorgesehen sein, wie exemplarisch Fig. 4, die die Rückseite des Keramikbauteils 1 zeigt, darstellt. Die Anordnung der durch die metallische Schicht 7 gebildeten Anschlusskontakte erfolgt vorzugsweise auf der Rückseite des Keramiksubstrates 2. Dies ermöglicht die einfache und kostengünstige Verbindung des Keramikbauteiles 1 mit einem Anschlussbauteil 12, beispielsweise mit dem Gehäuse eines Steuergerätes für eine Kfz-Anwendung, wie dies in Fig. 4 gezeigt ist. In diesem Ausführungsbeispiel wird ein BGA 10 verwendet, um die durch die metallische Schicht 7 gebildeten Anschlusskontakte des Keramikbauteils 1 mit Anschlusskontakten 13 des Anschlussbauteils 12 zu verbinden. Jeweils eine Lotperle 11 des BGAs 10 ist auf eine sich im Bereich der Kontaktierungsöffnung 6 aufgebrachte metallische Schicht 7 aufgesetzt. Das Verbinden mit den ebenfalls metallischen Anschlusskontakten 13 des Anschlussbauteils 12 erfolgt mittels Löten.

## Patentansprüche

1. Verfahren zur Herstellung eines Keramikbauteils (1), umfassend die Schritte: a) Bereitstellen eines Keramiksubstrates (2), wobei sich im Inneren und/oder an der Oberfläche des Keramiksubstrates (2) eine Leiterbahn (3) befindet, und das Keramiksubstrat (2) zumindest bereichsweise mit einer Glasur (5) bedeckt ist, und vor dem Aufbringen der Glasur (5) auf das Keramiksubstrat (2) ein Antihaftmittel (8) auf den Kontaktbereich (15) der Leiterbahn (3) aufgebracht wird; b) Erzeugen einer Kontaktierungsöffnung (6) in der Glasur (5) in einem Bereich eines zu kontaktierenden Kontaktbereiches (15) der Leiterbahn (3); c) Aufbringen einer metallischen Schicht (7) im Bereich der Kontaktierungsöffnung (6) zum Kontaktieren der Leiterbahn (3) im Kontaktbereich (15).

2. Verfahren nach Anspruch 1, wobei zum Aufbringen der metallischen Schicht (7) ein chemisch-stromloses Beschichtungsverfahren verwendet wird.

3. Verfahren nach Anspruch 1 oder 2, wobei das Antihaftmittel (8) ein Keramikpulver ist, dessen Sintertemperatur größer ist als die Erweichungstemperatur der Glasur (5).

4. Verfahren nach einem der Ansprüche 1 bis 3, wobei in einem weiteren Schritt das Antihaftmittel (8) zum Freilegen des Kontaktbereiches (15) der Leiterbahn (3) entfernt wird.

5. Verfahren nach Anspruch 4, wobei das Entfernen des Antihaftmittels (8) sich anschließend an die Erzeugung der Kontaktierungsöffnung (6) oder sich mit der Erzeugung der Kontaktierungsöffnung (6) zumindest abschnittsweise überlappend erfolgt.

6. Verfahren nach einem der vorhergehenden Ansprüche, wobei die Erzeugung der Kontaktierungsöffnung (6) und gegebenenfalls das Entfernen des Antihaftmittels (8) ein Bestrahlen durch einen Material abtragenden Strahl (9), vorzugsweise durch einen Laserstrahl oder durch einen Wasserstrahl, vorzugsweise durch einen mit Abrasivmittel versetzten Wasserstrahl, umfasst.

7. Keramikbauteil , umfassend ein Keramiksubstrat (2), eine das Keramiksubstrat (2) zumindest bereichsweise bedeckende Glasur (5), und eine sich im Inneren und/oder an der Oberfläche des Keramiksubstrates (2) befindende Leiterbahn (3), wobei sich zwischen dem jeweiligen Kontaktbereich (15) der Leiterbahn (3) und der Glasur (5) eine Schicht aus einem Antihaftmittel (8) befindet.

8. Keramikbauteil nach Anspruch 7, wobei das Keramiksubstrat (2) mehrere Keramiksubstratlagen aufweist.

## Claims

1. Method for producing a ceramic component (1), comprising the following steps: a) providing a ceramic substrate (2), wherein a conductor track (3) is situated in the interior and/or on the surface of the ceramic substrate (2), and the ceramic substrate (2) is covered with a glaze (5) at least in regions, and before applying the glaze (5) to the ceramic substrate (2), an anti-adherent (8) is applied to the contact region (15) of the conductor track (3); b) producing a contact-making opening (6) in the glaze (5) in a region of a contact region (15) of the conductor track (3) with which contact is to be made; c) applying a metallic layer (7) in the region of the contact-making opening (6) for making contact with the conductor track (3) in the contact region (15).

2. Method according to Claim 1, wherein a chemical-electroless coating method is used for applying the metallic layer (7).

3. Method according to Claim 1 or 2, wherein the anti-adherent (8) is a ceramic powder, the sintering temperature of which is greater than the softening temperature of the glaze (5).

4. Method according to any of Claims 1 to 3, wherein, in a further step, the anti-adherent (8) is removed in order to uncover the contact region (15) of the conductor track (3).

5. Method according to Claim 4, wherein the removal of the anti-adherent (8) is effected after the production of the contact-making opening (6) or in a manner overlapping the production of the contact-making opening (6) at least in sections.

6. Method according to any of the preceding claims, wherein the production of the contact-making opening (6) and, if appropriate, the removal of the anti-adherent (8) comprise exposure to a material-removing beam/jet (9), preferably to a laser beam or to a water jet, preferably to a water jet admixed with an abrasive agent.

7. Ceramic component, comprising a ceramic substrate (2), a glaze (5) covering the ceramic substrate (2) at least in regions, and a conductor track (3) situated in the interior and/or on the surface of the ceramic substrate (2), wherein a layer of an anti-adherent (8) is situated between the respective contact region (15) of the conductor track (3) and the glaze (5).

8. Ceramic component according to Claim 7, wherein the ceramic substrate (2) has a plurality of ceramic substrate layers.

## Revendications

1. Procédé de fabrication d'un composant en céramique (1), comprenant les étapes suivantes:
a) préparation d'un substrat en céramique (2), dans lequel il se trouve une piste conductrice (3) à l'intérieur et/ou à la surface du substrat en céramique (2) et le substrat en céramique (2) est recouvert au moins localement d'un vernis (5) et, avant l'application du vernis (5) sur le substrat en céramique (2), on applique un agent anti-adhérence (8) sur la zone de contact (15) de la piste conductrice (3);
b) production d'une ouverture de mise en contact (6) dans le vernis (5) dans une région d'une zone de contact (15) de la piste conductrice (3) à mettre en contact;
c) dépôt d'une couche métallique (7) dans la région de l'ouverture de mise en contact (6) pour la mise en contact de la piste conductrice (3) dans la zone de contact (15).

2. Procédé selon la revendication 1, dans lequel on utilise un procédé de revêtement chimique sans courant pour le dépôt de la couche métallique (7).

3. Procédé selon la revendication 1 ou 2, dans lequel l'agent anti-adhérence (8) est une poudre de céramique, dont la température de frittage est supérieure à la température de ramollissement du vernis (5).

4. Procédé selon l'une quelconque des revendications 1 à 3, dans lequel, dans une autre étape, on enlève l'agent anti-adhérence (8) pour dégager la zone de contact (15) de la piste conductrice (3).

5. Procédé selon la revendication 4, dans lequel on opère l'enlèvement de l'agent anti-adhérence (8) à la suite de la production de l'ouverture de mise en contact (6) ou en chevauchement, au moins partiellement, avec la production de l'ouverture de mise en contact (6).

6. Procédé selon l'une quelconque des revendications précédentes, dans lequel la production de l'ouverture de mise en contact (6) et éventuellement l'enlèvement de l'agent anti-adhérence (8) comprend l'exposition à un faisceau (9) d'enlèvement de matière, de préférence un faisceau laser ou un jet d'eau, de préférence un jet d'eau mélangé à un agent abrasif.

7. Composant en céramique, comprenant un substrat en céramique (2), un vernis (5) recouvrant au moins localement le substrat en céramique (2), et une piste conductrice (3) se trouvant à l'intérieur et/ou à la surface du substrat en céramique (2), dans lequel il se trouve une couche en un agent anti-adhérence (8) entre la zone de contact respective (15) de la piste conductrice (3) et le vernis (5).

8. Composant en céramique selon la revendication 7, dans lequel le substrat en céramique (2) présente plusieurs couches de substrat en céramique.
